# EUROPEAN PATENT APPLICATION

(11) **EP 4 307 396 A1**
(43) Date of publication of application: **17.01.2024**
(21) Application number: 22306042.7
(22) Date of filing: 11.07.2022
(51) Int. Cl.: H01L 31/107, H01L 31/02, H01L 31/0352, H01L 27/144, H01L 27/146

(54) **SINGLE PHOTON AVALANCHE DIODE**

(71) Applicant: STMicroelectronics (Research & Development) Limited, Marlow SL7 1EY (GB); STMicroelectronics Crolles 2 SAS, 38920 Crolles (FR)
(72) Inventor: NICHOLSON, Isobel, EDINBURGH, EH11 1EQ (GB); PELLEGRINI, Sara, EDINBURGH, EH13 0NA (GB); GOLANSKI, Dominique, 38610 GIERES (FR); LOPEZ, Alexandre, EDINBURH, EH89SQ (GB)
(74) Representative: Cabinet Beaumont

(57) **Abstract**

The present disclosure relates to a device comprising a single photon avalanche diode (12) in a portion of a substrate (50), the portion having an octagonal profile.

## Description

### Technical field

The present disclosure relates generally to optoelectronic devices and more precisely devices comprising single photon avalanche diode.

### Background art

A single-photon avalanche diode (SPAD) is a solid-state photodetector within the same family as photodiodes and avalanche photodiodes (APDs), while also being fundamentally linked with basic diode behaviors. As with photodiodes and APDs, a SPAD is based around a semi-conductor p-n junction that can be illuminated with ionizing radiation. The fundamental difference between SPADs and APDs or photodiodes, is that a SPAD is biased well above its reverse-bias breakdown voltage and has a structure that allows operation without damage or undue noise.

The electric field is high enough that a single charge carrier injected into the depletion layer can trigger a self-sustaining avalanche. The current continues until the avalanche is quenched. To that end, the SPAD is associated with a quenching circuit.

### Summary of Invention

One embodiment addresses all or some of the drawbacks of known optoelectronic devices comprising a SPAD.

One embodiment provides a device comprising a single photon avalanche diode in a portion of a substrate, the portion having an octagonal profile.

According to an embodiment, the single photon avalanche diode is surrounded by a first wall forming an octagonal contour around the portion.

According to an embodiment, the first wall comprises a sheath in an electrically insulating material and a core in an optically insulating material.

According to an embodiment, the portion comprises an insulating trench, a face of the trench being coplanar with a face of the portion, a conductive track, having two extremities, extending on said face of the trench.

According to an embodiment, the trench is located in the anode of the single photon avalanche diode.

According to an embodiment, the device comprises an array of single photon avalanche diodes.

According to an embodiment, each single photon avalanche diode is surrounded by a first wall, the first walls being distinct.

According to an embodiment, the single photon avalanche diodes are surrounded by a common wall separating the portions.

According to an embodiment, the device comprises an array of diodes, the lines of the array of single photon avalanche diodes being separated from each other by lines of the array of diodes, the columns of the array of single photon avalanche diodes being separated from each other by columns of the array of diodes.

According to an embodiment, the diodes are at substantially equal distance to four single photon avalanche diodes.

According to an embodiment, each diode is surrounded by a second wall, located between the diode and the closest first walls.

Another embodiment provides a device comprising a single photon avalanche diode and a resistor, the resistor resting on an insulating trench located in the anode of the single photon avalanche diode.

According to an embodiment, the single photon avalanche diode is made in a portion of a substrate.

According to an embodiment, the portion is surrounded by an insulating wall.

According to an embodiment, the anode of the single photon avalanche diode comprises a region having an upper face coplanar with the upper face of the portion.

According to an embodiment, the trench is in the region.

According to an embodiment, the region and the trench have the form of a ring.

According to an embodiment, the region and the trench surround the cathode of the single photon avalanche diode.

According to an embodiment, the resistor is made of a conductive track resting on the trench.

According to an embodiment, the conductive track is in polycrystalline silicon.

According to an embodiment, the portion has an octagonal profile.

Another embodiment provides a method of manufacturing a device comprising:
a. the formation of an insulating trench in a substrate;
b. the doping of the substrate in order to form a single photon avalanche diode, the insulating trench being located in the anode of the single photon avalanche diode; and
c. the formation of a resistor resting on the insulating trench.

According to an embodiment, the method comprises, between the steps a and b, the formation of an insulating wall surrounding the single photon avalanche diode.

### Brief description of drawings

The foregoing features and advantages, as well as others, will be described in detail in the following description of specific embodiments given by way of illustration and not limitation with reference to the accompanying drawings, in which:
Figure 1 illustrates an optoelectronic device comprising a SPAD;
Figure 2A is a top view of an embodiment of an optoelectronic device comprising at least a SPAD;
Figure 2B is a side view of the embodiment of Figure 2A;
Figure 3 is a top view of another embodiment of an optoelectronic device comprising at least a SPAD;
Figure 4A is a top view of an embodiment of an optoelectronic device comprising at least a SPAD; and
Figure 4B is a side view of the embodiment of Figure 4A.

### Description of embodiments

Like features have been designated by like references in the various figures. In particular, the structural and/or functional features that are common among the various embodiments may have the same references and may dispose identical structural, dimensional and material properties.

For the sake of clarity, only the operations and elements that are useful for an understanding of the embodiments described herein have been illustrated and described in detail.

Unless indicated otherwise, when reference is made to two elements connected together, this signifies a direct connection without any intermediate elements other than conductors, and when reference is made to two elements coupled together, this signifies that these two elements can be connected or they can be coupled via one or more other elements.

In the following disclosure, unless indicated otherwise, when reference is made to absolute positional qualifiers, such as the terms "front", "back", "top", "bottom", "left", "right", etc., or to relative positional qualifiers, such as the terms "above", "below", "higher", "lower", etc., or to qualifiers of orientation, such as "horizontal", "vertical", etc., reference is made to the orientation shown in the figures.

Unless specified otherwise, the expressions "around", "approximately", "substantially" and "in the order of" signify within 10 %, and preferably within 5 %.

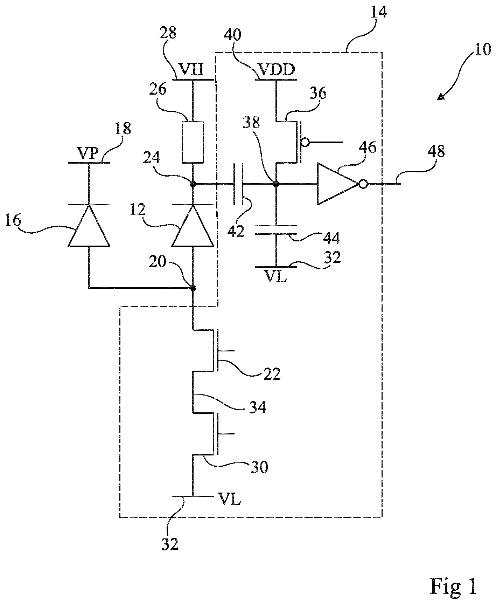

Figure 1 illustrates an optoelectronic device. More precisely, Figure 1 illustrates schematically a circuit 10, corresponding to a part of a SPAD pixel, in other word a SPAD-based pixel.

The circuit 10 comprises a single-photon avalanche diode 12 (SPAD), configured to start an avalanche on detection of a photon. For example, the circuit 10 comprises a single SPAD 12. Pixel 10 further comprises a quench circuit 14, configured to detect the current flowing through the photodiode and to turn it off by lowering the biasing of the junction below the breakdown voltage. The quenching circuit 14 then recharges the junction by reapplying the initial voltage enabling to detect a new photon.

Circuit 10 comprises a protection diode 16. Diode 16 is a so-called "pull-up" diode. Diode is preferably not a SPAD. Diode 16 is coupled, preferably connected, between a node 18 of application of a voltage VP and a node 20. The cathode of diode 16 is coupled, preferably connected, to node 20 and the anode of diode 16 is coupled, preferably connected, to the node of application of voltage VP. The diode 16 is a disabling diode, allowing the node of the anode of the SPAD 12 to be held at a voltage value for example equal to 7 V when the SPAD diode is disabled by a transistor 22. The disabling voltage VP has a value for example at least 2 V larger than the excess bias applied to the SPAD beyond the breakdown voltage

SPAD 12 is coupled, preferably connected, between node 20 and a node 24. The cathode of SPAD 24 is coupled, preferably connected, to node 24 and the anode of cathode 12 is coupled, preferably connected, to node 20. Circuit 10 further comprises a resistor 26 coupled, preferably connected, between node 24 and a node 28 of application of a voltage VH.

The quench circuit 14 comprises the transistor 22 and a transistor 30 coupled, preferably connected, in series between the node 20 and a node 32 of application of a voltage VL, for example, the ground. More particularly, transistor 22 is coupled, preferably connected, by its conduction terminals (for example, source and drain) between node 20 and a node 34. Transistor 30 is coupled, preferably connected, by its conduction terminals between node 34 and the node 32 of application of voltage VL.

Transistors 22 and 30 are preferably N-type field-effect (MOS) transistors.

Circuit 14 further comprises a transistor 36 coupled, preferably connected, by its conduction terminals between a node 38 and a node 40 of application of a power supply voltage VDD. Transistor 36 preferably is a P-type field effect transistor. Circuit 14 further comprises capacitive elements or capacitors 42 and 44. Capacitor 42 is coupled, preferably connected, between node 38 and node 24. Capacitor 44 is coupled, preferably connected, between node 38 and node 32 of application of voltage VL. Circuit 14 for example comprises an inverter circuit 46 coupled, preferably connected, between node 38 and an output node 48, the input of circuit 46 being coupled, preferably connected, to node 38 and the output of circuit 46 being coupled, preferably connected, to node 48.

The different elements of circuit 10 are for example located on different level of a device.

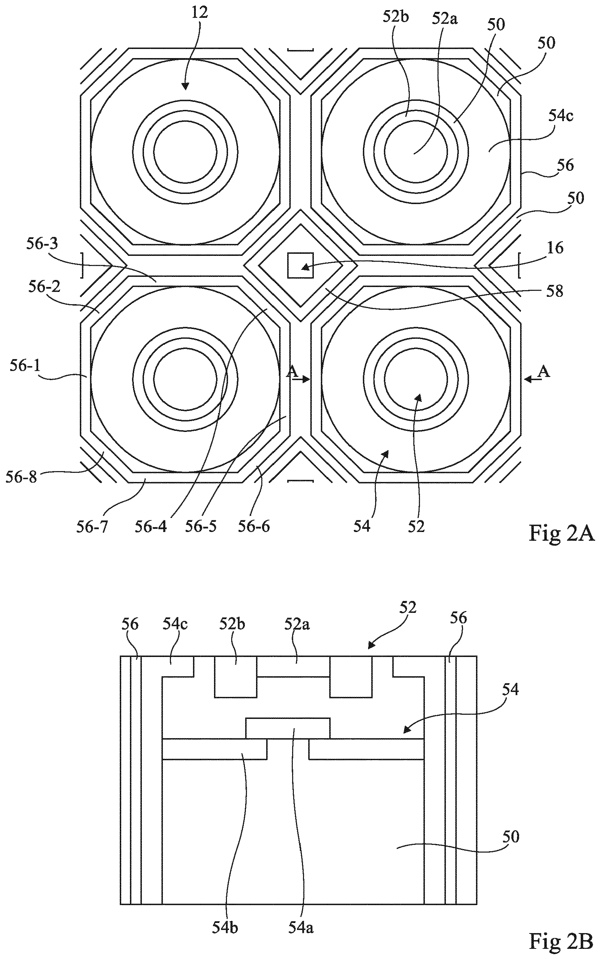

Figure 2A is a top view of an embodiment of an optoelectronic device comprising at least a SPAD. Figure 2B is a side view of the embodiment of Figure 2A. More precisely, Figure 2B is a view of the embodiment of Figure 2A in a plan A-A.

Figure 2A and Figure 2B illustrate a level comprising the SPAD 12 of Figure 1 and the diode 16 of Figure 1. In other words, Figure 2A and Figure 2B represents a substrate 50, on and in which SPAD 12 and the diode 16 are formed. The substrate 50 is a semiconductor substrate, for example in silicon. Preferably, other components of the circuit 10 of Figure 1 are formed in another level, meaning in and on another substrate. For example, the quenching circuit 14 is formed in and on another substrate.

The device for example comprises a plurality of pixels, or circuits, 10. For example, all the SPAD 12 and the diodes 16 of the device are located in the same level, meaning in and on the same substrate. In the example of Figure 2A, four SPAD are represented. A single SPAD is represented in Figure 2B.

Each SPAD 12 comprises a cathode 52 and an anode 54. The cathode 52 for example comprises a first region 52a and a second region 52b. The anode 54 comprises a first part 54a, a second part 54b and a third part 54c.

First region 52a is a n-doped semiconductor region. Region 52a for example crop out at the upper face of the substrate 50. In other words, the upper face of the region 52a is coplanar with the upper face of the substrate 50. Region 52a for example has a cylindrical form. For example, region 52a has, in the top view, a circular form. In other words, the upper face of the region 52a has a circular form. Alternatively, region 52a has, in the top view, the form of a rectangle, preferably a square, with smoothed angles.

Second region 52b is a n-doped semiconductor region. Region 52b for example crop out at the upper face of the substrate 50. The upper face of the region 52a is coplanar with the upper face of the substrate 50 and with the upper face of the region 52a. Region 52b laterally surround region 52a. In other words, region 52b forms a ring around region 52a. Region 52a is preferably in contact with region 52b. Preferably, the lateral face of region 52a is entirely in contact with the lateral face of region 52b, specifically with the internal lateral face of region 52b.

Each region 52a, 52b has preferably a doping concentration substantially constant. The dopant concentration of region 52a is for example lower than the dopant concentration in region 52b. The height of region 52b, in other words the distance between the upper face and the lower face, is for example higher than the height of region 52a.

First region 54a is a p-doped semiconductor region. Region 54a is for example buried in the substrate 50. Region 54a for example has a cylindrical form. For example, region 54a has, in a top view, a circular form. In other words, the upper face of the region 54a has a circular form. Alternatively, region 54a has, in the top view, the form of a rectangle, preferably a square, with smoothed angles. Region 54a is for example located under region 52a. In other words, at least part of region 54a is vertically aligned with a part of region 52a. Region 54a is separated from region 52a and from region 52b by a portion of the substrate 50.

Region 54b is a p-doped semiconductor region. Region 54b is for example buried in the substrate 50. Region 54b is preferably located under the region 54a. In other words, the region 54a is preferably located between region 54b and the cathode 52. Region 54b has for example the form of a ring. Region 54b laterally surrounds a portion of the substrate 50 vertically aligned with region 54a. Region 54b and region 54a are preferably in contact. Part of the upper face of region 54b is preferably in contact with the lower face of region 54a.

Region 54c is a p-doped semiconductor region. Region 54c extends vertically in the substrate 50. Region 54c extends from the upper face of the substrate 50 to at least the level of the region 54b. Regions 54b and 54c are in contact, for example laterally. The upper face of the region 54c is for example coplanar with the upper face of the substrate 50. The width of the region 54c is for example higher at the level of the upper face of the substrate than at the level of the region 54b. For example, the region 54c comprises an upper part, having a first, preferably substantially constant, width, and a lower part having a second, preferably substantially constant, width. The second width is for example lower than the first width. Region 54c has, in a top view, the form of a ring. Region 54c surrounds the cathode 52, both regions 52a and 52b, and the regions 54a and 54b. Region 54c is separated from regions 52a and 52b by a portion of the substrate 50.

Each region 54a, 54b, 54c has preferably a doping concentration substantially constant. The dopant concentration of region 54a is for example lower than the dopant concentration in region 54b. The dopant concentration of region 54b is for example lower than the dopant concentration in region 54c.

Each SPAD is surrounded by a wall 56. Preferably, the walls 56 surrounding the different SPAD have the same dimensions.

Preferably, the wall 56 extends, vertically, on the entire height of the corresponding SPAD. Preferably, the wall 56 extends, vertically, at least from the point of the cathode 52 and anode 54 the closest to the upper face of the substrate to the point of the cathode 52 and anode 54 the farthest to the upper face of the substrate. In other words, in the example of Figure 2A and Figure 2B, the wall 56 extends, vertically, at least from the upper face of the cathode, corresponding to the upper face of the substrate and to the upper face of the region 54c, to the lower face of the region 54c, corresponding for example to the lower face of the substrate 50.

Each wall 56 surrounds laterally the corresponding SPAD. In other words, each SPAD is, preferably entirely, separated from the neighboring SPAD by a portion of the wall 56. In the example of Figure 2A and Figure 2B, each SPAD is surrounded by a wall 56 associated to said SPAD and distinct from the walls 56 surrounding the other SPAD. Therefore, two neighboring SPAD are separated by portions of two different walls. In the example of Figure 2A and 2B, the different walls, surrounding the different SPAD, are not in contact. In other words, the different walls, surrounding the different SPAD, are separated from each other by portions of the substrate 50.

Each wall 56 has, in top view, in other words in the plan of the upper face of the substrate, an octagonal form. In other words, the internal lateral face of the wall 56, meaning the lateral face of the wall 56 the closest to the SPAD, has the form of an octagon. Similarly, the external lateral face of the wall 56, meaning the lateral face of the wall 56 the farthest to the SPAD, has the form of an octagon. Therefore, the wall 56 forms an octagonal contour around the SPAD. The SPAD region, in other words the region of the substrate 50 in which the SPAD is formed, is bordered by the wall 56. Said portion therefore has an octagonal profile.

More precisely, in any plan parallel to the upper face of the substrate 50 comprising a wall 56, meaning in any plan parallel to the plan of Figure 2A comprising a wall 56, each wall 56 comprises eight portions 56-1, 56-2, 56-3, 56-4, 56-5, 56-6, 56-7, 56-8, forming the octagon. The portion 56-1 is in contact with the dimensions 56-8 and 56-2. The portion 56-2 is in contact with the dimensions 56-1 and 56-3. The portion 56-3 is in contact with the dimensions 56-2 and 56-4. The portion 56-4 is in contact with the dimensions 56-3 and 56-5. The portion 56-5 is in contact with the dimensions 56-4 and 56-6. The portion 56-6 is in contact with the dimensions 56-5 and 56-7. The portion 56-7 is in contact with the dimensions 56-6 and 56-8. The portion 56-8 is in contact with the dimensions 56-7 and 56-1. By two portions in contact, it is meant that a face of the two portions is common to the two portions.

Each portion of the wall 56 preferably has a rectangular or trapezoidal form in any plan parallel to the upper face of the substrate 50 comprising a wall 56. Preferably, the portions are parallelepipeds.

The portions 56-1, 56-2, 56-3, 56-4 are for example respectively parallel to the portions 56-5, 56-6, 56-7, 56-8. In other words, the portions 56-1, 56-2, 56-3, 56-4 for example respectively extends in directions parallel to the directions in which the portions 56-5, 56-6, 56-7, 56-8 extend. In other words, in any plan parallel to the upper face of the substrate 50 comprising a wall 56, the directions corresponding to the highest dimension of the portions 56-1, 56-2, 56-3, 56-4 are for example respectively parallel to the directions corresponding to the highest dimension of the portions 56-5, 56-6, 56-7, 56-8. Furthermore, the portions 56-1, 56-2, 56-3, 56-4, 56-5, 56-6, 56-7, 56-8 are for example respectively orthogonal to the portions 56-3, 56-4, 56-5, 56-6, 56-7, 56-8, 56-1, 56-2.

The portions of a wall 56 that are parallel to each other preferably have the same dimensions. In other words, the portions 56-1 and 56-5, respectively the portions 56-2 and 56-6, respectively the portions 56-3 and 56-7, respectively the portions 56-4 and 56-8, preferably have the same dimensions. Preferably, the portions of a wall 56 that are orthogonal to each other have the same dimensions. In other words, the portions 56-1, 56-3, 56-5, 56-7 have the same dimensions and the portions 56-2, 56-4, 56-6, 56-8 have the same dimensions.

In the example of Figure 2A, the corresponding portions are parallel to each other. In other words, the portions 56-1, 56-2, 56-3, 56-4, 56-5, 56-6, 56-7, 56-8 of a wall 56 are respectively parallel to the portions 56-1, 56-2, 56-3, 56-4, 56-5, 56-6, 56-7, 56-8 of the other walls 56. The SPAD and the walls 56 surrounding the SPAD are for example disposed in an array, forming lines and columns of SPAD. For example, the portions 56-1 and 56-5 of a wall 56 are respectively aligned with the portions 56-1 and 56-5 of the walls 56 of the same column. Similarly, the portions 56-3 and 56-7 of a wall 56 are for example respectively aligned with the portions 56-3 and 56-7 of the walls 56 of the same line. Similarly, the portions 56-2, 56-4, 56-6 and 56-8 of a wall 56 are for example respectively aligned with the portions 56-2, 56-4, 56-6 and 56-8 of the walls 56 located diagonally in the array to the wall 56.

The substrate 50 for example comprises an array of diodes 16. The diodes are preferably formed by n-doped and p-doped regions in the substrate. Every line of SPAD is separated from the neighboring line of SPAD by a line of diodes 16. Every column of SPAD is separated from the neighboring column of SPAD by a column of diodes 16. Therefore, each diode 16 is surrounded by four SPAD.

Preferably, each diode 16 is located at an equal distance to said four SPAD. Each diode 16 is for example located at the center of a square formed by four SPAD. Each diode 16 is located in a portion of the substrate 50 delimited by a portion of each of said four SPAD. More precisely, said portion is delimited by a portion 56-2 of a wall 56 surrounding a first SPAD, a portion 56-4 of a wall 56 surrounding a second SPAD located in the same line as the first SPAD, a portion 56-6 of a wall 56 surrounding a third SPAD located in the same column as the second SPAD, and a portion 56-8 of a wall 56 surrounding a fourth SPAD located in the same column as the first SPAD and in the same line as the third SPAD. The first, second, third and fourth SPAD are the closest SPAD to the diode.

Each diode 16 is for example surrounded by a wall 58. The wall 58 separates the diode 16 from the SPAD 12. The wall 58 separates the diode 16 from the walls 56 of the neighboring SPAD 12. Therefore, each diode 16 is separated from each neighboring SPAD by a portion of a wall 56 and a portion of a wall 58. In the example of Figure 2A, the walls 56 are distinct from the walls 58. In other words, the walls 56 and 58 are not in contact. Each wall 58 is separated from the walls 56 by portions of the substrate 50.

Preferably, the walls 56 are electrically and optically insulating. The walls 56 are for example of the back-side deep trench insulation (BDTI) type. The walls 56 for example comprises a sheath in an electrically insulating material and a core in an optically insulating material, for example in metal. By optically insulating material, it is meant a material at least partially opaque, preferably entirely opaque, to the working wavelength of the SPAD, for example all wavelength of the visible range and/or all wavelength of the near infrared range. The walls 58 are electrically insulating. The walls 58 are for example of the deep trench insulating (DTI) type. The walls 58 are for example in an oxide, for example in silicon oxide. Alternatively, the walls 58 can also be of the back-side deep trench insulation (BDTI) type.

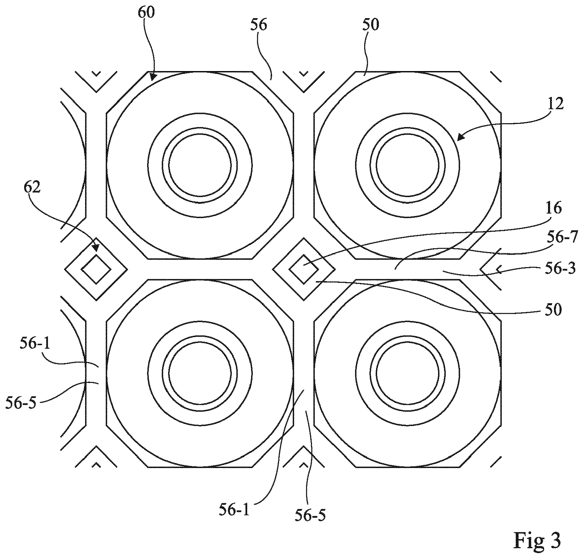

Figure 3 is a top view of another embodiment of an optoelectronic device comprising at least a SPAD 12.

The device of Figure 3 comprises the elements of Figure 2A and 2B, which will not be described again. In particular, the device of Figure 3 comprises the SPAD 12, the walls 56, the diode 16, the substrate 50.

The device of Figure 3 differs from the device of Figure 2A and Figure 2B in that the walls 56 have common portions. In other words, the distinct walls 56 are replaced by a common and unique wall. More precisely, the portion 56-3 of a wall 56 surrounding a SPAD is common with the portion 56-7 of the wall 56 surrounding another SPAD of the same column. Similarly, the portion 56-1 of a wall 56 surrounding a SPAD is common with the portion 56-5 of the wall 56 surrounding another SPAD of the same line.

The common wall separates different portions of the substrate 50. The common wall separated an array of portions 60, in which a SPAD 12, preferably a single SPAD 12, is formed, and portions 62, in which a diode 16, preferably a single diode 16, is formed. The portions 60 correspond to the portions of the substrate 50 surrounded by the walls 56 in Figure 2A. Therefore, the portions 60 have, in a plan parallel to the upper face of the substrate, the form of an octagon. In other words, the edges of each portion 60, that is the lateral faces in contact with the wall, form, in a top view, an octagon.

The portions 62 are located at the emplacements of the diodes 16 in Figure 2A. In the example of Figure 3, the walls 58 are not present. Each diode is separated from the neighboring SPAD by a single portion of the wall 56, and portions of the substrate 50. Alternatively, the walls 58 cans be present between each diode and the closest portions of the wall 56.

An advantage of the embodiments described above is that the photons absorbed in the portion of the substrate corresponding to each SPAD are quicker to reach the doped regions of the SPAD. Indeed, in SPAD located in square or rectangular portions of the substrate, the photons absorbed in the corners of the square or of the rectangle have the longest distance to the doped regions and lead to a long jitter tail. The described embodiments therefore have better timing characteristics.

Another advantage of the embodiments described above is that the diodes 16 can be located in the portions where the corners were removed, which allows for the density of SPAD arrays to be higher.

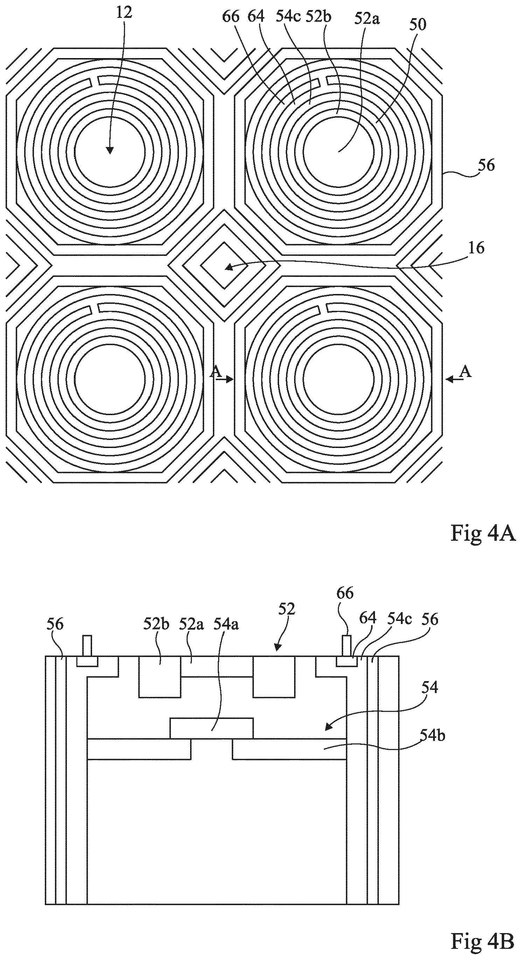

Figure 4A is a top view of an embodiment of an optoelectronic device comprising a SPAD. Figure 4B is a side view of the embodiment of Figure 4A.

The device of Figure 4A and 4B comprises the elements of Figure 2A and 2B, which will not be described again. In particular, the device of Figure 3 comprises the SPAD 12, the walls 56, the diode 16, the substrate 50.

The device of Figure 4A and Figure 4B differs from the device of Figure 2A and Figure 2B in that an insulating trench 64 is formed in the anode of each SPAD, for example in the region 54c of each SPAD. In other words, the trench 64 is located in a p-doped region. The trench 64 is preferably of the shallow trench isolation (STI) type. The trench 64 has for example the form of a ring. The trench 64 surround for example the cathode. In other words, the trench 64 form a ring around the regions 52a and 52b.

The trench 64 preferably crop up to the upper face of the substrate 50. In other words, the upper face of the trench 64 is coplanar with the upper face of the substrate 50. The trench 64 for example has a height lower that the height of the upper part of the region 54c. Therefore, the lateral faces and the lower face of the trench are covered by the region 54c.

A conductive track 66 is located on the trench 64 of each SPAD 12. The conductive track 66 constitutes the resistor 26 of Figure 1. The conductive track 66 is in a material allowing the formation of a resistance. The conductive track 66 is for example in polycrystalline silicon, for example in doped polycrystalline silicon.

The conductive track 66 rests on the upper face of the trench 64. The track 66 is separated from the doped regions of the SPAD, in particular from the region 54c, by the insulating trench 64. The track 66 for example the form of an open ring. In other words, the track 66 forms a ring comprising an opening. The track therefore comprises two extremities, corresponding to the terminals of the resistor 26. The dimensions of the track 66, in particular the length of the track 66, and the size of the opening are for example determined in function of the wanted resistance of the resistor 26.

While the embodiment of Figure 4A and Figure 4B comprises walls 56 having the form of an octagon corresponding to the embodiment of Figure 2A and Figure 2B, the trench 64 and the conductive track 66 can be implemented on different SPAD. For example, the trench 64 and the conductive track 66 can be implemented in any of the embodiments described in relation with Figures 2A to 3. More generally, the trench 64 and the conductive track 66 can be implemented in any SPAD independent on the form of the walls surrounding the SPAD. For example, the trench 64 and the conductive track 66 can be implemented on a SPAD being surrounded by a wall having a square or rectangular form, instead of an octagonal form.

As a variant, at least some of the regions of the cathode 52 can be buried in the substrate 50. For example, the regions 52a and 52b can be buried in the substrate 50.

A method of manufacturing the device of Figures 4A and 4B for example comprises:
- the formation, in the substrate 50, of the shallow trench isolation, for example the trench 64;
- the formation, in the substrate, of the deep trench isolation, and of the back-side deep trench isolation;
- the doping of the substrate in order to form the doped regions of the SPAD, in other words the regions 52a, 52b, 54a, 54b, 54c;
- the formation, in polycrystalline silicon of the track 66 on the trench 64; and
- the doping of the polycrystalline silicon.

An advantage of the embodiment describes is that the presence of a p-doped region between the trench 64 and the other doped region of the SPAD ensure that the dark count rate is not affected by the presence of the track 66.

Another advantage of the embodiments described is that forming the resistor 26 on the SPAD, for example instead of between the SPAD, allows to increase the density of SPAD in the substrate.

Various embodiments and variants have been described. Those skilled in the art will understand that certain features of these embodiments can be combined and other variants will readily occur to those skilled in the art.

Finally, the practical implementation of the embodiments and variants described herein is within the capabilities of those skilled in the art based on the functional description provided hereinabove.

## Claims

1. A device comprising a single photon avalanche diode (12) in a portion of a substrate (50), the portion having an octagonal profile.

2. The device according to claim 1, wherein the single photon avalanche diode (12) is surrounded by a first wall (56) forming an octagonal contour around the portion.

3. The device according to claim 2, wherein the first wall (56) comprises a sheath in an electrically insulating material and a core in an optically insulating material.

4. The device according to any of claims 1 to 3, wherein the portion comprises an insulating trench (64), a face of the trench (64) being coplanar with a face of the portion, a conductive track (66), having two extremities, extending on said face of the trench.

5. The device according to claim 4, wherein the trench (64) is located in the anode (54) of the single photon avalanche diode (12).

6. The device according to any of claims 1 to 5, wherein the device comprises an array of single photon avalanche diodes (12) .

7. The device according to claims 2 and 6, wherein each single photon avalanche diode (12) is surrounded by a first wall (56), the first walls (56) being distinct.

8. The device according to claims 2 and 6, wherein the single photon avalanche diodes (56) are surrounded by a common wall (56) separating the portions.

9. The device according to any of claims 6 to 8, wherein the device comprises an array of diodes (16), the lines of the array of single photon avalanche diodes (12) being separated from each other by lines of the array of diodes (16), the columns of the array of single photon avalanche diodes (12) being separated from each other by columns of the array of diodes (16).

10. The device according to claim 9, wherein the diodes (16) are at substantially equal distance to four single photon avalanche diodes (12).

11. The device according to claim 9 or 10, wherein each diode (16) is surrounded by a second wall (58), located between the diode (16) and the closest first walls (56).

## Amended claims

### Amended claims in accordance with Rule 137(2) EPC.

1. A device comprising an array of single photon avalanche diodes (12), each single photon avalanche diode (12) being in a portion of a substrate (50), each portion having an octagonal profile, each single photon avalanche diode (12) being surrounded by a first wall (56) forming an octagonal contour around the portion, each first wall comprising two first portions (56-1, 56-5) parallel to each other, two second portions (56-2, 56-6) parallel to each other, two third portions (56-3, 56-7) parallel to each other and two fourth portions (56-4, 56-8) parallel to each other, the first and third portions being orthogonal to each other and the second and fourth portions being orthogonal to each other, the first walls of two single photon avalanche diodes (12) of the same column having a third portion in common and the first walls of two single photon avalanche diodes (12) of the same row having a first portion in common, the device comprising an array of diodes (16), each diode (16) being in a portion of substrate delimited by the second and fourth portion of the adjacent first walls.

2. The device according to claim 1, wherein the first wall (56) comprises a sheath in an electrically insulating material and a core in an optically insulating material.

3. The device according to claim 1 or 2, wherein the portion comprises an insulating trench (64), a face of the trench (64) being coplanar with a face of the portion, a conductive track (66), having two extremities, extending on said face of the trench.

4. The device according to claim 3, wherein the trench (64) is located in the anode (54) of the single photon avalanche diode (12).

5. The device according to any of claims 1 to 4, wherein the lines of the array of single photon avalanche diodes (12) being separated from each other by lines of the array of diodes (16), the columns of the array of single photon avalanche diodes (12) being separated from each other by columns of the array of diodes (16).

6. The device according to any of claims 1 to 5, wherein the diodes (16) are at substantially equal distance to four single photon avalanche diodes (12).

7. The device according to any of claims 1 to 6, wherein each diode (16) is surrounded by a second wall (58), located between the diode (16) and the closest first walls (56).
